# EUROPEAN PATENT APPLICATION

(11) **EP 1 818 917 A1**
(43) Date of publication of application: **15.08.2007**
(21) Application number: 06253324.5
(22) Date of filing: 26.06.2006
(51) Int. Cl.: G11B 5/851, C23C 14/34, G11B 5/73

(54) **Ruthenium alloy magnetic media and sputter targets**

(30) Priority: 14.02.2006 US 353141
(71) Applicant: Heraeus, Inc., Chandler AZ 85226 (US)
(72) Inventor: Das, Anirban, Tempe, AZ 85283 (US); Racine, Michael Gene, Phoenix, AZ 85044 (US)
(74) Representative: Hill, Justin John

(57) **Abstract**

A magnetic recording medium having an underlayer comprised of ruthenium (Ru) and an alloying element is provided. The alloying element may be for refining grain size, when it has little or no solid solubility in HCP phase Ru and is present in an amount in excess ofthat solubility. The alloying element may be for reducing lattice misfit, where it has some solid solubility in HCP phase Ru and is present in an amount not exceeding that solubility. The alloying element may be for both refining grain size and reducing lattice misfit, where it has some solid solubility in HCP phase Ru and is present in an amount in excess of that solubility. The underlayer may alternately include ruthenium and two alloying elements, one for refining grain size, the other for reducing lattice misfit. A sputter target comprising ruthenium and an alloying element is also provided.

## Description

### FIELD OF THE INVENTION

The present invention generally relates to sputter targets and magnetic recording media, and, in particular, relates to ruthenium-based sputter targets and underlayers in magnetic recording media for perpendicular magnetic recording.

### BACKGROUND OF THE INVENTION

To satisfy the continual demand for even greater data storage capacities, higher density magnetic recording media are required. Of the approaches to achieve this high data density, perpendicular magnetic recording (PMR) by far appears to be the most promising. It is desirable to provide well-isolated fine grain structure coupled with large perpendicular magnetic anisotropy Kᵤ to achieve low media noise (e.g., a higher signal-to-noise ratio) performance and high thermal stability in a granular magnetic layer of a magnetic media stack for PMR.

Additionally, close lattice matching between a crystalline underlayer and the overlying granular magnetic layer is desirable to ensure a nearly defect-free interface to reduce any contribution to in-plane magnetization.

### SUMMARY OF THE INVENTION

In accordance with the present invention, a magnetic recording medium having a ruthenium-based underlayer is provided. The underlayer is comprised of ruthenium and a weakly-magnetic alloying element. The alloying element may be for refining grain size, when it has little or no solid solubility in hexagonal close-packed (HCP) phase Ru and is present in the alloy in an amount in excess of that solubility. The alloying element may be for reducing lattice misfit, where it has some solid solubility in HCP phase Ru and is present in the underlayer in an amount not exceeding that solubility. The alloying element may be for both refining grain size and reducing lattice misfit, where it has some solid solubility in HCP phase Ru and is present in the underlayer in an amount in excess of that solubility. The underlayer may alternately include ruthenium and two alloying elements, one for refining grain size, the other for reducing lattice misfit. These enhancements will improve the signal-to-noise ratio (SNR) and the perpendicular magnetic anisotropy Kᵤ of the magnetic recording medium. Alternately, sputter target comprised of one of the ruthenium-based alloys described above is provided for sputtering an underlayer in a magnetic recording medium.

According to one embodiment, the present invention is a magnetic recording medium. The magnetic recording medium includes a first layer comprised of ruthenium (Ru) and an alloying element. The alloying element is selected from the group consisting of boron (B), aluminum (Al), silicon (Si), manganese (Mn), germanium (Ge), selenium (Se), zirconium (Zr), silver (Ag), tin (Sn), ytterbium (Yb), lutetium (Lu), hafnium (Hf), osmium (Os), gold (Au), bismuth (Bi) and thallium (Th). The alloying element is present in the first layer in an amount exceeding a solid solubility limit of the alloying element in HCP phase ruthenium (Ru) at or above room temperature.

The underlayer may further include a second alloying element. The second alloying element has a solid solubility limit in hexagonal close-packed (HCP) phase ruthenium of greater than 0 atomic percent at or above room temperature and a mass susceptibility of less than 1.5 × 10⁻⁷ m³/kg. The second alloying element is present in the sputter target in an amount not exceeding the solid solubility limit of the second alloying element.

According to another embodiment, a magnetic recording medium of the present invention includes a first layer comprised of ruthenium (Ru) and an alloying element. The alloying element is selected from the group consisting of boron (B), aluminum (Al), scandium (Sc), titanium (Ti), zirconium (Zr), niobium (Nb), palladium (Pd), lanthanum (La), cesium (Ce), lutetium (Lu), and hafnium (Hf). The alloying element is present in the first layer in an amount not exceeding a solid solubility limit of the alloying element in hexagonal close-packed (HCP) phase ruthenium (Ru) at or above room temperature.

According to yet another embodiment, a magnetic recording medium of the present invention includes a first layer comprised of ruthenium (Ru) and an alloying element. The alloying element is selected from the group consisting of boron (B), aluminum (Al), scandium (Sc), titanium (Ti), zirconium (Zr), niobium (Nb), palladium (Pd), lanthanum (La), cesium (Ce), lutetium (Lu), and hafnium (Hf). The alloying element is present in the first layer in an amount exceeding a solid solubility limit of the alloying element in hexagonal close-packed (HCP) phase ruthenium (Ru) at or above room temperature.

According to yet another embodiment, the present invention is a sputter target including ruthenium (Ru) and an alloying element. The alloying element is selected from the group consisting of boron (B), aluminum (Al), silicon (Si), manganese (Mn), germanium (Ge), selenium (Se), zirconium (Zr), silver (Ag), tin (Sn), ytterbium (Yb), lutetium (Lu), hafnium (Hf), osmium (Os), gold (Au), bismuth (Bi) and thallium (Th). The alloying element is present in the sputter target in an amount exceeding a solid solubility limit of the alloying element in hexagonal close-packed (HCP) phase ruthenium (Ru) at or above room temperature.

The sputter target may further includes a second alloying element. The second alloying element has a solid solubility limit in hexagonal close-packed (HCP) phase ruthenium of greater than 0 atomic percent at or above room temperature and a mass susceptibility of less than 1.5 × 10⁻⁷ m³/kg. The second alloying element is present in the sputter target in an amount not exceeding the solid solubility limit of the second alloying element.

According to yet another embodiment, a sputter target of the present invention includes ruthenium (Ru) and an alloying element. The alloying element is selected from the group consisting of boron (B), aluminum (Al), scandium (Sc), titanium (Ti), zirconium (Zr), niobium (Nb), palladium (Pd), lanthanum (La), cesium (Ce), lutetium (Lu), and hafnium (Hf). The alloying element is present in the sputter target in an amount not exceeding a solid solubility limit of the alloying element in hexagonal close-packed (HCP) phase ruthenium (Ru) at or above room temperature.

According to yet another embodiment, a sputter target of the present invention includes ruthenium (Ru) and an alloying element. The alloying element is selected from the group consisting of boron (B), aluminum (Al), scandium (Sc), titanium (Ti), zirconium (Zr), niobium (Nb), palladium (Pd), lanthanum (La), cesium (Ce), lutetium (Lu), and hafnium (Hf). The alloying element is present in the sputter target in an amount exceeding a solid solubility limit of the alloying element in hexagonal close-packed (HCP) phase ruthenium (Ru) at or above room temperature.

Additional features and advantages of the invention will be set forth in the description below, and in part will be apparent from the description, or may be learned by practice of the invention. The objectives and other advantages of the invention will be realized and attained by the structure particularly pointed out in the written description and claims hereof as well as the appended drawings.

It is to be understood that both the foregoing general description and the following detailed description are exemplary and explanatory and are intended to provide further explanation of the invention as claimed.

### BRIEF DESCRIPTION OF THE DRAWINGS

The accompanying drawings, which are included to provide further understanding of the invention and are incorporated in and constitute a part of this specification, illustrate embodiments of the invention and together with the description serve to explain the principles of the invention. In the drawings:

Figure I illustrates a magnetic recording medium according to one embodiment of the present invention;

Figure 2 illustrates a sputter target according to another embodiment of the present invention; and

Figure 3 is a graph illustrating the variation in the a-axis lattice parameter of a CoPt-based magnetic recording layer with varying platinum content according to one aspect of the present invention.

### DETAILED DESCRIPTION OF THE INVENTION

In the following detailed description, numerous specific details are set forth to provide a full understanding of the present invention. It will be apparent, however, to one ordinarily skilled in the art that the present invention may be practiced without some of these specific details. In other instances, well-known structures and techniques have not been shown in detail to avoid unnecessarily obscuring the present invention.

1. Ru-X

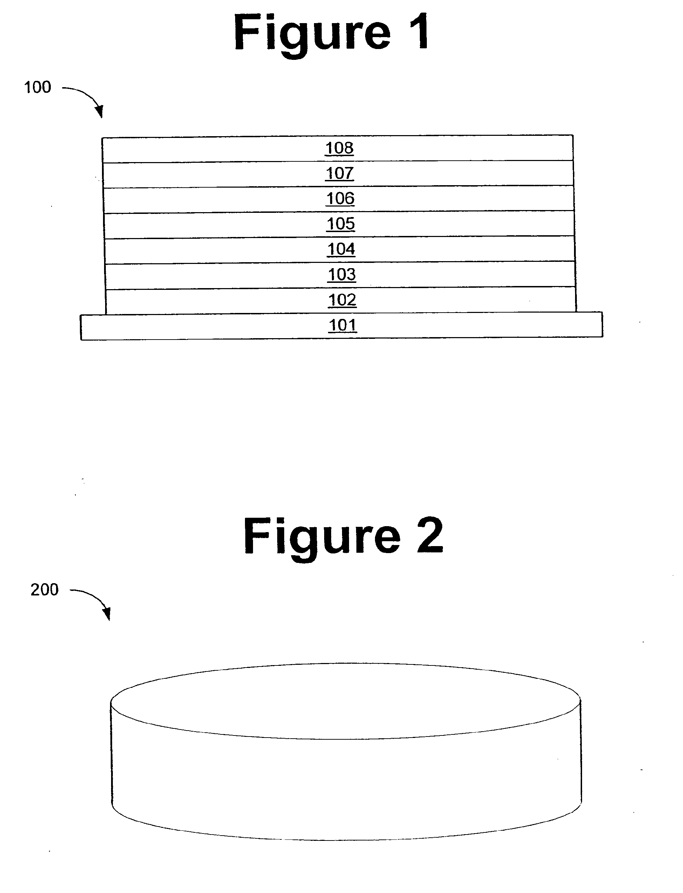

Figure 1 illustrates a magnetic recording media stack 100 according to one embodiment of the present invention. A media stack such as media stack 100 may include a substrate 101 (*e.g.,* glass or aluminum (Al)), a seed layer 104, an underlayer 105 and a magnetic recording layer 106. Media stack 100 may also include one or more soft underlayers with or without other non-magnetic or magnetic layers, such as layers 102 and 103, disposed on substrate 101. Media stack may further include a lube layer and a carbon overcoat with or without other magnetic or non-magnetic layers, such as layers 107 and 108.

An oxygen-containing CoPt-based granular magnetic medium may be used in magnetic recording layer 106. The oxygen in magnetic recording layer 106 forms an amorphous hard brittle grain boundary region, thereby confining the grain growth and refining the grain size in the magnetic recording layer 106. Other CoPt(Cr)(B)-based magnetic layers of low or high moment may also be deposited on top of this granular magnetic recording layer 106, to adjust the M_{S} (saturation magnetization), commensurate with the head design. The granular magnetic recording layer 106 may be deposited on a weakly-magnetic (almost non-magnetic) crystalline (HCP phase) underlayer, such as underlayer 105, which acts to enhance the Co [0002] texture of the CoPt-based granular magnetic recording layer 106 in a direction perpendicular to the plane in which the magnetic recording layer 106 lies, thereby contributing to a very high perpendicular anisotropy.

A crystalline underlayer with refined grain sizes, such as underlayer 105, can potentially help in the grain size reduction of a granular magnetic recording layer 106 deposited epitaxially on top of it. This effect can be enhanced when underlayer 105 comprises an alloy of ruthenium (Ru) and a grain size refining element X. To act as a grain size refiner, the alloying element X needs to have substantially no solid solubility (*e*.*g*., < 10 atomic percent (at. %)) in HCP phase ruthenium at or above room temperature. This insolubility will permit the alloying element to form amorphous grain boundaries in the ruthenium-based underlayer 105, thereby confining grain growth during sputtering of the underlayer 105 and subsequent layers.

Moreover, the alloying element X is non-magnetic or weakly magnetic (e.g., with a mass susceptibility of < 1.5 × 10⁻⁷ m³/kg). Based on this and the above criteria, elements such as the elements in Table 1 are excellent candidates for grain size refining alloying element X. For example, alloying element X may be any one of boron (B), aluminum (Al), silicon (Si), manganese (Mn), germanium (Ge), selenium (Se), zirconium (Zr), silver (Ag), tin (Sn), ytterbium (Yb), lutetium (Lu), hafnium (Hf), osmium (Os), gold (Au), bismuth (Bi) or thallium (Th).

**Table 1**

| | **Atomic No.** | **Atomic Radius** | **Crystal Structure** | **Mass Suscept. (10⁻⁸ m³/kg)** | **Solubility in Ru** |
|---|---|---|---|---|---|
| B | 5 | 0.97 | RHOMB | -0.87 | 2%(1660°C), Insoluble(RT) |
| C | 6 | 0.77 | DIAMOND | -0.62 | 3%(1940°C), Insoluble(RT) |
| Al | 13 | 1.43 | FCC | 0.82 | 4%(1920°C), 1%(RT) |
| Si | 14 | 1.32 | DIAMOND | -0.16 | Insoluble |
| Mn | 25 | 1.35 | CUB | 12.2 | Insoluble |
| Cu | 26 | 1.28 | FCC | -0.1 | Insoluble |
| Ge | 32 | 1.39 | DIAMOND | -0.15 | Insoluble |
| Se | 34 | 1.16 | HCP | -0.4 | Insoluble |
| Zr | 40 | 1.6 | HCP | 1.66 | 1.9%(1715°C), Insoluble (400°C) |
| Ag | 47 | 1.44 | FCC | -0.23 | Insoluble |
| Sn | 50 | 1.58 | DIAMOND | -0.31 | Insoluble |
| Yb | 70 | 1.93 | FCC | 0.59 | Insoluble |
| Lu | 71 | 1.73 | HCP | 0.12 | 2-3%(1250°C), Insoluble (RT) |
| Hf | 72 | 1.59 | HCP | 0.53 | 2-3% (1200°C), Insoluble (RT) |
| Re | 75 | 1.41 | HCP | 0.46 | Insoluble |
| Os | 76 | 1.38 | HCP | 0.06 | Insoluble |
| Au | 79 | 1.44 | FCC | -0.18 | Insoluble |
| Bi | 83 | 1.75 | RHOMB | -1.7 | Insoluble |
| Th | 90 | 1.8 | FCC | 0.53 | Insoluble |

The grain size refining alloying element X can be added to the ruthenium-based underlayer 105 in any amount in excess of its maximum solid solubility limit in HCP phase ruthenium at room temperature or higher.

Underlayer 105 may be sputter deposited from a sputter target such as a sputter target 200 in Figure 2 according to one embodiment of the present invention. Like underlayer 105, sputter target 200 may include ruthenium (Ru) and a grain size refining alloying element X. To act as a grain size refiner, the alloying element X needs to have substantially no solid solubility (*e.g*., < 10 atomic percent (at. %)) in HCP phase ruthenium at or above room temperature. Moreover, the alloying element X is non-magnetic or weakly magnetic (*e.g*., with a mass susceptibility of < 1.5 × 10⁻⁷ m³/kg). Finally, alloying element X is added to the sputter target 200 in any amount in excess of its maximum solid solubility limit in HCP phase ruthenium at room temperature or higher. Alloying element X is present in the sputter target in an amount exceeding a solid solubility limit of the alloying element in hexagonal close-packed (HCP) phase ruthenium (Ru) at or above room temperature.

2. Ru-Y

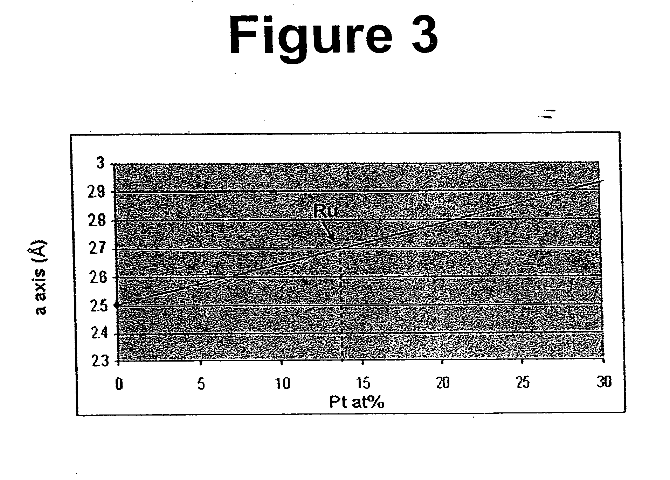

Turning again to Figure 1, another embodiment of the present invention may be illustrated with reference to the magnetic recording media stack 100 illustrated therein. A CoPt-based granular magnetic recording layer 106 is deposited on top of a HCP phase ruthenium-based underlayer 105. As platinum is highly soluble in cobalt at room temperature, the incorporation of platinum in cobalt can significantly change (linearly as predicted by Vegard's law) the lattice constant of the magnetic recording layer 106. Figure 3 shows the variation in the a-axis lattice parameter in a CoPt-based magnetic recording layer with varying platinum content.

When magnetic recording media stack 100 is used for perpendicular magnetic recording (PMR), the CoPt-based magnetic recording layer 106 should be in the HCP phase with a strong out-of-plane orientation along the [0002] direction. A ruthenium-based underlayer 105 enhances the crystalline structure of the magnetic recording layer 106 if the HCP [0002] planes of ruthenium are oriented parallel to the interface of underlayer 105 and magnetic recording layer 106. However, any lattice misfit at the interface contributes to residual stress, potentially creating defects in the magnetic recording media stack 100, and can further increase undesirable in-plane magnetization.

To minimize the lattice misfit between underlayer 105 and the magnetic recording layer 106 disposed on top of it, underlayer 105 may comprise ruthenium (Ru) and a lattice misfit reducing alloying element Y. It is evident from Figure 3 that, if the platinum content in the magnetic recording layer 106 is less than 14 atomic percent (as apparent from the linear extrapolation of the lattice parameters of Co and Pt as per Vegard's law), the lattice misfit reducing alloying element Y needs to have an atomic radius lower than that of ruthenium. On the other hand, if the platinum content in the magnetic recording layer 106 is higher than 14 atomic percent, the lattice misfit reducing alloying element Y needs to have an atomic radius higher than that of ruthenium.

The lattice misfit reducing alloying element Y needs to have some solid solubility in Ru at room temperature or above, so that it forms a solid solution with ruthenium and thereby modifies the in-plane (a lattice) parameter of underlayer 105. The lattice misfit reducing alloying element Y is also non-magnetic or weakly magnetic (*e.g*., with a mass susceptibility of < 1.5 × 10⁻⁷ m³/kg). Based on this and the above criteria, the elements in Tables 2 and 3 are excellent candidates for lattice misfit reducing alloying element Y.

For a CoPt-based magnetic recording layer with < 14 at.% platinum, the lattice misfit reducing alloying element Y needs to have atomic radius lower than that of ruthenium so that the a-axis lattice parameter in the ruthenium-based underlayer 105 is reduced. Table 2 provides a list of elements which have an atomic radius lower than that of ruthenium (*e.g.*, lower than 1.30 Å) and satisfy the other above-described criteria for lattice misfit reducing alloying element Y. For example, alloying element Y may be any one of boron (B), carbon (C) or chromium (Cr).

**Table 2**

| | **Atomic No.** | **Atomic Radius** | **Crystal Structure** | **Mass Suscept. (10⁻⁸ m³/kg)** | **Solubility in Ru** |
|---|---|---|---|---|---|
| B | 4 | 0.97 | RHOMB | -0.87 | 2%(1660°C), Insoluble(RT) |
| C | 6 | 0.77 | DIAMOND | -0.62 | 3%(1940°C), Insoluble(RT) |
| Cr | 24 | 1.28 | BCC | 4.45 | 52.5(1610°C), 40%(300°C) |

For a CoPt-based magnetic recording layer with > 14 at.% platinum, the lattice misfit reducing alloying element Y needs to have atomic radius higher than that of ruthenium so that the a-axis lattice parameter in the ruthenium-based underlayer 105 is increased. Table 3 provides a list of elements which have an atomic radius higher than that of ruthenium (e.g., higher than 1.30 Å) and satisfy the other above-described criteria for lattice misfit reducing alloying element Y. For example, alloying element Y may be any one of aluminum (Al), scandium (Sc), titanium (Ti), vanadium (V), zirconium (Zr), niobium (Nb), molybdenum (Mo), palladium (Pd), lanthanum (La), cesium (Ce), lutetium (Lu), hafnium (Hf), tantalum (Ta), tungsten (W), iridium (Ir) or platinum (Pt).

**Table 3**

| | **Atomic No.** | **Atomic Radius** | **Crystal Structure** | **Mass Suscept. (10⁻⁸ m³/kg)** | **Solubility in Ru** |
|---|---|---|---|---|---|
| Al | 13 | 1.43 | FCC | 0.82 | 4%(1920°C), 1 %(RT) |
| Sc | 21 | 1.6 | FCC | 8.8 | 2%(1100°C), Insoluble(RT) |
| Ti | 22 | 1.47 | HCP | 4.21 | 14%(1825°C), 2.5%(600°C) |
| V | 23 | 1.36 | BCC | 6.28 | 31 % (1790°C), 17%(700°C) |
| Zr | 40 | 1.6 | HCP | 1.66 | 1.9%(1715°C), Insoluble(400°C) |
| Nb | 41 | 1.47 | BCC | 2.81 | 29(1774°C), 5%(1000°C) |
| Mo | 42 | 1.4 | BCC | 1.17 | 51.5%(1915°C), 38%(RT) |
| Pd | 46 | 1.37 | FCC | 6.57 | 17%(1583°C), 1%(600°C) |
| La | 57 | 1.87 | HCP | 1.02 | 2%(1431°C), Insoluble(RT) |
| Ce | 58 | 1.82 | HCP | 22 | 2%(1400°C), Insoluble(RT) |
| Lu | 71 | 1.73 | HCP | 0.12 | 2-3%(1250°C), Insoluble(RT) |
| Hf | 72 | 1.59 | HCP | 0.53 | 2-3% (1200°C), Insoluble(RT) |
| Ta | 73 | 1.47 | BCC | 1.07 | 28%(1667°C), 20%(750°C) |
| W | 74 | 1.41 | BCC | 0.39 | 48%(2205°C), 39%(1500°C) |
| Ir | 77 | 1.35 | FCC | 0.23 | 49%(2334°C), 45%(800°C) |
| Pt | 78 | 1.38 | FCC | 1.22 | 21%(~2100°C), 20%(1000°C) |

The lattice misfit reducing alloying element Y can be added to the ruthenium-based underlayer 105 in any amount not exceeding its maximum solid solubility limit in HCP phase ruthenium at room temperature or higher.

Underlayer 105 may be sputter deposited from a sputter target such as sputter target 200 in Figure 2 according to one embodiment of the present invention. Like underlayer 105, sputter target 200 may include ruthenium (Ru) and a lattice misfit reducing alloying element Y. Lattice misfit reducing alloying element Y needs to have some solid solubility in Ru at room temperature or above. Moreover, alloying element Y is non-magnetic or weakly magnetic (*e*.*g*., with a mass susceptibility of < 1.5 × 10⁻⁷ m³/kg). For increasing the a-axis lattice parameter of a ruthenium-based underlayer sputtered from sputter target 200, alloying element Y needs to be an element having an atomic radius greater than that of ruthenium. For decreasing the a-axis lattice parameter in a ruthenium-based underlayer sputtered from sputter target 200, alloying element Y needs to be an element having an atomic radius less than that of ruthenium. Alloying element Y is added to the sputter target 200 in any amount not exceeding its maximum solid solubility limit in HCP phase ruthenium at room temperature or higher.

3. Ru-Z

Turning again to Figure 1, another embodiment of the present invention may be illustrated with reference to the magnetic recording media stack 100 illustrated therein. A CoPt-based granular magnetic recording layer 106 is deposited on top of a HCP ruthenium-based underlayer 105. Underlayer 105 may comprise ruthenium (Ru) and a single alloying element Z that can act as both a grain size refining alloying element and a lattice misfit reducing alloying element. This single alloying element Z may act as a lattice misfit reducing element if the alloying element Z has some solid solubility in HCP phase Ru at room temperature or higher and therefore forms a solid solution with ruthenium, thereby affecting its a-axis lattice parameter. This single alloying element Z may also act as a grain size refiner if the alloying element Z is added in excess of its solubility limit (e.g., in excess of that solubility limit by as much as 10 at.%). In another embodiment, Z may be added in excess of its solubility limit by any amount (e.g., by not more than 10 at.% or by more than 10 at.%).

For increasing the a-axis lattice parameter in the ruthenium-based underlayer 105, single alloying element Z needs to be an element having an atomic radius greater than that of ruthenium. For decreasing the a-axis lattice parameter in the ruthenium-based underlayer 105, single alloying element Z needs to be an element having an atomic radius less than that of ruthenium.

The single alloying element Z is non-magnetic or weakly magnetic *(e.g.,* with a mass susceptibility of < 1.5 × 10⁻⁷ m³/kg). Based on this and the above criteria, the elements in Table 4 are excellent candidates for single alloying element Z for refining grain size and reducing lattice misfit. For example, single alloying element Z may be any one of boron (B), carbon (C), aluminum (Al), scandium (Sc), titanium (Ti), vanadium (V), chromium (Cr), zirconium (Zr), niobium (Nb), molybdenum (Mo), palladium (Pd), lanthanum (La), cesium (Ce), lutetium (Lu), hafnium (Hf), tantalum (Ta), tungsten (W), iridium (Ir) or platinum (Pt).

**Table 4**

| | **Atomic No.** | **Atomic Radius** | **Crystal Structure** | **Mass Suscept. (10⁻⁸ m³/kg)** | **Solubility in Ru** |
|---|---|---|---|---|---|
| B | 4 | 0.97 | RHOMB | -0.87 | 2%(1660°C), Insoluble(RT) |
| C | 6 | 0.77 | DIAMOND | -0.62 | 3%(1940°C), Insoluble(RT) |
| Al | 13 | 1.43 | FCC | 0.82 | 4%(1920°C), 1%(RT) |
| Sc | 21 | 1.6 | FCC | 8.8 | 2%(1100°C), Insoluble(RT) |
| Ti | 22 | 1.47 | HCP | 4.21 | 14% (1825°C), 2.5%(600°C) |
| V | 23 | 1.36 | BCC | 6.28 | 31% (1790°C), 17%(700°C) |
| Cr | 24 | 1.28 | BCC | 4.45 | 52.5(1610°C), 40%(300°C) |
| Zr | 40 | 1.6 | HCP | 1.66 | 1.9%(1715°C), Insoluble(400°C) |
| Nb | 41 | 1.47 | BCC | 2.81 | 29(1774°C), 5%(1000°C) |
| Mo | 42 | 1.4 | BCC | 1.17 | 51.5%(1915°C), 38%(RT) |
| Pd | 46 | 1.37 | FCC | 6.57 | 17%(1583°C), 1%(600°C) |
| La | 57 | 1.87 | HCP | 1.02 | 2%(1431°C), Insoluble(RT) |
| Ce | 58 | 1.82 | HCP | 22 | 2%(1400°C), Insoluble(RT) |
| Lu | 71 | 1.73 | HCP | 0.12 | 2-3%(1250°C), Insoluble(RT) |
| Hf | 72 | 1.59 | HCP | 0.53 | 2-3% (1200°C), Insoluble(RT) |
| Ta | 73 | 1.47 | BCC | 1.07 | 28%(1667°C), 20%(750°C) |
| W | 74 | 1.41 | BCC | 0.39 | 48%(2205°C), 39%(1500°C) |
| Ir | 77 | 1.35 | FCC | 0.23 | 49%(2334°C), 45%(800°C) |
| Pt | 78 | 1.38 | FCC | 1.22 | 21%(~2100°C), 20%(1000°C) |

The single alloying element Z can be added to the ruthenium-based underlayer 105 in any amount in excess of its maximum solid solubility limit in HCP phase ruthenium at room temperature or higher (*e*.*g*., in excess of that solubility limit by as much as 10 at.%).

Underlayer 105 may be sputter deposited from a sputter target such as sputter target 200 in Figure 2 according to one embodiment of the present invention. Like underlayer 105, sputter target 200 may include ruthenium (Ru) and a single alloying element Z for grain size refining and lattice misfit reducing. This single alloying element Z may act as a lattice misfit reducing element if the alloying element Z has some solid solubility in HCP phase Ru at room temperature or higher and therefore forms a solid solution with ruthenium, thereby affecting its a-axis lattice parameter. This single alloying element Z may also act as a grain size refiner if the alloying element Z is added in excess of its solubility limit (*e.g*., in excess of that solubility limit by as much as 10 at.%). In another embodiment. Z may be added in excess of its solubility limit by any amount (*e.g*., by not more than 10 at.% or by more than 10 at.%). For increasing the a-axis lattice parameter in a ruthenium-based underlayer sputtered from sputter target 200, single alloying element Z needs to be an element having an atomic radius greater than that of ruthenium. For decreasing the a-axis lattice parameter in a ruthenium-based underlayer sputtered from sputter target 200, single alloying element Z needs to be an element having an atomic radius less than that of ruthenium. The single alloying element Z is non-magnetic or weakly magnetic (*e.g*., with a mass susceptibility of < 1.5 × 10⁻⁷ m³/kg).

4. Ru-X-Y

Turning again to Figure 1, another embodiment of the present invention may be illustrated with reference to the magnetic recording media stack 100 illustrated therein. A CoPt-based granular magnetic recording layer 106 is deposited on top of a HCP ruthenium-based underlayer 105. Underlayer 105 may comprise a ternary ruthenium-based alloy Ru-X-Y, where X is a grain size reducing alloying element and Y is a lattice misfit reducing alloying element.

To act as a grain size refiner, the alloying element X needs to have substantially no solid solubility (*e.g*., < 10 at.%) in HCP phase ruthenium at room temperature or above. Moreover, the alloying element X is non-magnetic or weakly magnetic (*e.g*., with a mass susceptibility of < 1.5 × 10⁻⁷ m³/kg). Finally, alloying element X is added to the ruthenium-based underlayer 105 in any amount in excess of its maximum solid solubility limit in HCP phase ruthenium at room temperature or higher.

Lattice misfit reducing alloying element Y needs to have some solid solubility in Ru at room temperature or above. Moreover, alloying element Y is non-magnetic or weakly magnetic (*e.g*., with a mass susceptibility of < 1.5 × 10⁻⁷ m³/kg). For increasing the a-axis lattice parameter in the ruthenium-based underlayer 105, alloying element Y needs to be an element having an atomic radius greater than that of ruthenium. For decreasing the a-axis lattice parameter in the ruthenium-based underlayer 105, alloying element Y needs to be an element having an atomic radius less than that of ruthenium. Finally, alloying element Y is added to the ruthenium-based underlayer 105 in any amount not exceeding its maximum solid solubility limit in HCP phase ruthenium at room temperature or higher.

Based on these criteria, Table 5 provides a list of candidates for grain size refining alloying element X and lattice misfit reducing alloying element Y.

**Table 5**

| **Grain Size Refining Alloying Element X** | **Lattice Misfit Reducing Alloying Element Y (for Pt > 14 at.%)** | **Lattice Misfit Reducing Alloying Element Y (for Pt < 14 at.%)** |
|---|---|---|
| B (2-50 at.%) | Al (0-4 at.%) | B (0-2 at.%) |
| C (3-50 at.%) | Sc (0-2 at.%) | C (0-3 at.%) |
| Al (4-50 at.%) | Ti (0-14 at.%) | Cr (up to 50 at.%) |
| Si (up to 50 at.%) | V (0-31 at.%) | |
| Mn (up to 50 at.%) | Zr (0-2 at.%) | |
| Cu (up to 50 at.%) | Nb (0-29 at.%) | |
| Ge (up to 50 at.%) | Mo (up to 50 at.%) | |
| Se (up to 50 at.%) | Pd (0-17 at.%) | |
| Zr (2-50 at.%) | La (0-2 at.%) | |
| Ag (up to 50 at.%) | Ce (0-2 at.%) | |
| Sn (up to 50 at.%) | Lu (0-3 at.%) | |
| Yb (up to 50 at.%) | Hf (0-3 at.%) | |
| Lu (3-50 at.%) | Ta (0-28 at.%) | |
| Hf (3-50 at.%) | W (0-48 at.%) | |
| Re (up to 50 at.%) | Ir (0-49 at.%) | |
| Os (up to 50 at.%) | Pt (0-21 at.%) | |
| Au (up to 50 at.%) | | |
| Bi (up to 50 at.%) | | |
| Th (up to 50 at.%) | | |

Underlayer 105 may be sputter deposited from a sputter target such as sputter target 200 in Figure 2 according to one embodiment of the present invention. Like underlayer 105, sputter target 200 may include ruthenium (Ru), a grain size refining alloying element X, and a lattice misfit reducing alloying element Y. To act as a grain size refiner, the alloying element X needs to have substantially no solid solubility (*e.g*., < 10 at.%) in HCP phase ruthenium at room temperature or above. Moreover, the alloying element X is non-magnetic or weakly magnetic (e.g., with a mass susceptibility of < 1.5 × 10⁻⁷ m³/kg). Finally, alloying element X is added to the sputter target 200 in any amount in excess of its maximum solid solubility limit in HCP phase ruthenium at room temperature or higher. Lattice misfit reducing alloying element Y needs to have some solid solubility in Ru at room temperature or above. Moreover, alloying element Y is non-magnetic or weakly magnetic (e.g., with a mass susceptibility of < 1.5 × 10⁻⁷ m³/kg). For increasing the a-axis lattice parameter in a ruthenium-based underlayer sputtered from sputter target 200, alloying element Y needs to be an element having an atomic radius greater than that of ruthenium. For decreasing the a-axis lattice parameter in a ruthenium-based underlayer sputtered from sputter target 200, alloying element Y needs to be an element having an atomic radius less than that of ruthenium. Finally, alloying element Y is added to sputter target 200 in any amount not exceeding its maximum solid solubility limit in HCP phase ruthenium at room temperature or higher.

While the present invention has been particularly described with reference to the various figures and embodiments, it should be understood that these are for illustration purposes only and should not be taken as limiting the scope of the invention. There may be many other ways to implement the invention. For example, the present invention may be applicable to longitudinal magnetic recording. Granular magnetic recording layer 106 may be any CoPt-based magnetic layer with or without oxygen. A media stack may include more or less layers than those shown in Figure 1. While a round sputter target is shown in Figure 2, a sputter target may be in any number of other shapes, such as rectilinear, solid or hollow cylindrical, or nearly any other shape. Many changes and modifications may be made to the invention, by one having ordinary skill in the art, without departing from the spirit and scope of the invention.

## Claims

1. A magnetic recording medium, comprising:
a first layer comprised of ruthenium (Ru) and an alloying element,
the alloying element selected from the group consisting of boron (B), aluminum (Al), silicon (Si), manganese (Mn), germanium (Ge), selenium (Se), zirconium (Zr), silver (Ag), tin (Sn), ytterbium (Yb), lutetium (Lu), hafnium (Hf), osmium (Os), gold (Au), bismuth (Bi) and thallium (Th),
the alloying element present in the first layer in an amount exceeding a solid solubility limit of the alloying element in hexagonal close-packed (HCP) phase ruthenium (Ru) at or above room temperature.

2. The magnetic recording medium of claim 1, wherein the alloying element is present in the first layer in an amount no more than 10 atomic percent greater than the solid solubility limit of the alloying element in hexagonal close-packed (HCP) phase ruthenium (Ru) at or above room temperature.

3. The magnetic recording medium of claim 1, wherein the first layer further comprises a second alloying element,
the second alloying element having a solid solubility limit in hexagonal close-packed (HCP) phase ruthenium of greater than 0 atomic percent at or above room temperature,
the second alloying element having a mass susceptibility of less than 1.5 × 10⁻⁷ m³/kg,
the second alloying element present in the sputter target in an amount not exceeding the solid solubility limit of the second alloying element.

4. The magnetic recording medium of claim 3, wherein the second alloying element has an atomic radius of less than 1.30 Å.

5. The magnetic recording medium of claim 3, wherein the second alloying element is selected from the group consisting of boron (B), carbon (C) and chromium (Cr).

6. The magnetic recording medium of claim 3, wherein the second alloying element has an atomic radius of greater than 1.30 Å.

7. The magnetic recording medium of claim 3, wherein the second alloying element is selected from the group consisting of aluminum (Al), scandium (Sc), titanium (Ti), vanadium (V), zirconium (Zr), niobium (Nb), molybdenum (Mo), palladium (Pd), lanthanum (La), cesium (Ce), lutetium (Lu), hafnium (Hf), tantalum (Ta), tungsten (W), iridium (Ir) and platinum (Pt).

8. The magnetic recording medium of claim 1, wherein the magnetic recording medium is a perpendicular magnetic recording medium.

9. The magnetic recording medium of claim 1, further comprising a substrate, a seed layer, and a granular magnetic recording layer.

10. The magnetic recording medium of claim 9, wherein the alloying element is for refining grain size in the first layer and the granular magnetic recording layer.

11. A magnetic recording medium, comprising:
a first layer comprised of ruthenium (Ru) and an alloying element,
the alloying element selected from the group consisting of boron (B), aluminum (Al), scandium (Sc), titanium (Ti), zirconium (Zr), niobium (Nb), palladium (Pd), lanthanum (La), cesium (Ce), lutetium (Lu), and hafnium (Hf),
the alloying element present in the first layer in an amount not exceeding a solid solubility limit of the alloying element in hexagonal close-packed (HCP) phase ruthenium (Ru) at or above room temperature.

12. The magnetic recording medium of claim 11, further comprising a substrate, a seed layer, and a magnetic layer.

13. The magnetic recording medium of claim 12, wherein the alloying element is for reducing lattice misfit between the first layer and the magnetic layer.

14. A magnetic recording medium, comprising:
a first layer comprised of ruthenium (Ru) and an alloying element.
the alloying element selected from the group consisting of boron (B), aluminum (Al), scandium (Sc), titanium (Ti), zirconium (Zr), niobium (Nb), palladium (Pd), lanthanum (La), cesium (Ce), lutetium (Lu), and hafnium (Hf),
the alloying element present in the first layer in an amount exceeding a solid solubility limit of the alloying element in hexagonal close-packed (HCP) phase ruthenium (Ru) at or above room temperature.

15. The magnetic recording medium of claim 14, wherein the alloying element is present in the first layer in an amount no more than 10 atomic percent greater than the solid solubility limit of the alloying element in hexagonal close-packed (HCP) phase ruthenium (Ru) at or above room temperature.

16. The magnetic recording medium of claim 14, further comprising a substrate, a seed layer, and a magnetic layer.

17. The magnetic recording medium of claim 16, wherein the alloying element is for refining grain size in the first layer and the magnetic layer and for reducing lattice misfit between the first layer and the magnetic layer.

18. A sputter target comprising:
ruthenium (Ru); and
an alloying element selected from the group consisting of boron (B), aluminum (Al), silicon (Si), manganese (Mn), germanium (Ge), selenium (Se), zirconium (Zr), silver (Ag), tin (Sn), ytterbium (Yb), lutetium (Lu), hafnium (Hf), osmium (Os), gold (Au), bismuth (Bi) and thallium (Th),
the alloying element present in the sputter target in an amount exceeding a solid solubility limit of the alloying element in hexagonal close-packed (HCP) phase ruthenium (Ru) at or above room temperature.

19. The sputter target of claim 18, wherein the alloying element is present in the sputter target in an amount no more than 10 atomic percent greater than the solid solubility limit of the alloying element in hexagonal close-packed (HCP) phase ruthenium (Ru) at or above room temperature.

20. The sputter target of claim 18, wherein the alloying element is for refining grain size in an underlayer and a granular magnetic recording layer of a magnetic recording medium.

21. The sputter target of claim 18, further comprising a second alloying element,
the second alloying element having a solid solubility limit in hexagonal close-packed (HCP) phase ruthenium of greater than 0 atomic percent at or above room temperature,
the second alloying element having a mass susceptibility of less than 1.5 × 10⁻⁷ m³/kg,
the second alloying element present in the sputter target in an amount not exceeding the solid solubility limit of the second alloying element.

22. The sputter target of claim 21, wherein the second alloying element has an atomic radius of less than 1.30 Å.

23. The sputter target of claim 21, wherein the second alloying element is selected from the group consisting of boron (B), carbon (C) and chromium (Cr).

24. The sputter target of claim 21, wherein the second alloying element has an atomic radius of greater than 1.30 Å.

25. The sputter target of claim 21, wherein the second alloying element is selected from the group consisting of aluminum (Al), scandium (Sc), titanium (Ti), vanadium (V), zirconium (Zr), niobium (Nb), molybdenum (Mo), palladium (Pd), lanthanum (La), cesium (Ce), lutetium (Lu), hafnium (Hf), tantalum (Ta), tungsten (W), iridium (Ir) and platinum (Pt).

26. A sputter target comprising:
ruthenium (Ru); and
an alloying element selected from the group consisting of boron (B), aluminum (Al), scandium (Sc), titanium (Ti), zirconium (Zr), niobium (Nb), palladium (Pd), lanthanum (La), cesium (Ce), lutetium (Lu), and hafnium (Hf),
the alloying element present in the sputter target in an amount not exceeding a solid solubility limit of the alloying element in hexagonal close-packed (HCP) phase ruthenium (Ru) at or above room temperature.

27. The sputter target of claim 26, wherein the alloying element is for reducing lattice misfit between an underlayer and a granular magnetic recording layer of a magnetic recording medium.

28. A sputter target comprising:
ruthenium (Ru); and
an alloying element selected from the group consisting of boron (B), aluminum (Al), scandium (Sc), titanium (Ti), zirconium (Zr), niobium (Nb), palladium (Pd), lanthanum (La), cesium (Ce), lutetium (Lu), and hafnium (Hf),
the alloying element present in the sputter target in an amount exceeding a solid solubility limit of the alloying element in hexagonal close-packed (HCP) phase ruthenium (Ru) at or above room temperature.

29. The sputter target of claim 28, wherein the alloying element is present in the sputter target in an amount no more than 10 atomic percent greater than the solid solubility limit of the alloying element in hexagonal close-packed (HCP) phase ruthenium (Ru) at or above room temperature.

30. The sputter target of claim 28, wherein the alloying element is for refining grain size in an underlayer and a granular magnetic recording layer of a magnetic recording medium, and for reducing lattice misfit between the underlayer and the granular magnetic recording layer.

## Amended claims

### Amended claims in accordance with Rule 86(2) EPC.

**6.** The magnetic recording medium of claim 3, wherein the second alloying element has an atomic radius of greater than 1.30 Å.

**7.** The magnetic recording medium of claim 3, wherein the second alloying element is selected from the group consisting of aluminum (A1), scandium (Sc), titanium (Ti), vanadium (V), zirconium (Zr), niobium (Nb), molybdenum (Mo), palladium (Pd), lanthanum (La), cerium (Ce), lutetium (Lu), hafnium (Hf), tantalum (Ta), tungsten (W), iridium (Ir) and platinum (Pt).

**8.** The magnetic recording medium of claim 1, wherein the magnetic recording medium is a perpendicular magnetic recording medium.

**9.** The magnetic recording medium of claim 1, further comprising a substrate, a seed layer, and a granular magnetic recording layer.

**10.** The magnetic recording medium of claim 9, wherein the alloying element is for refining grain size in the first layer and the granular magnetic recording layer.

**11.** A magnetic recording medium, comprising:
a first layer comprised of ruthenium (Ru) and an alloying element,
the alloying element selected from the group consisting of boron (B), aluminum (Al), scandium (Sc), titanium (Ti), zirconium (Zr), niobium (Nb), palladium (Pd), lanthanum (La), cerium (Ce), lutetium (Lu), and hafnium (Hf),
the alloying element present in the first layer in an amount not exceeding a solid solubility limit of the alloying element in hexagonal close-packed (HCP) phase ruthenium (Ru) at or above room temperature.

**12.** The magnetic recording medium of claim 11, further comprising a substrate, a seed layer, and a magnetic layer.

**13.** The magnetic recording medium of claim 12, wherein the alloying element is for reducing lattice misfit between the first layer and the magnetic layer.

**14.** A magnetic recording medium, comprising:
a first layer comprised of ruthenium (Ru) and an alloying element,
the alloying element selected from the group consisting of boron (B), aluminum (Al), scandium (Sc), titanium (Ti), zirconium (Zr), niobium (Nb), palladium (Pd), lanthanum (La), cerium (Ce), lutetium (Lu), and hafnium (Hf),
the alloying element present in the first layer in an amount exceeding a solid solubility limit of the alloying element in hexagonal close-packed (HCP) phase ruthenium (Ru) at or above room temperature.

**15.** The magnetic recording medium of claim 14, wherein the alloying element is present in the first layer in an amount no more than 10 atomic percent greater than the solid solubility limit of the alloying element in hexagonal close-packed (HCP) phase ruthenium (Ru) at or above room temperature.

**16.** The magnetic recording medium of claim 14, further comprising a substrate, a seed layer, and a magnetic layer.

**17.** The magnetic recording medium of claim 16, wherein the alloying element is for refining grain size in the first layer and the magnetic layer and for reducing lattice misfit between the first layer and the magnetic layer.

**18.** A sputter target comprising:
ruthenium (Ru); and
an alloying element selected from the group consisting of boron (B), aluminum (A1), silicon (Si), manganese (Mn), germanium (Ge), selenium (Se), zirconium (Zr), silver (Ag), tin (Sn), ytterbium (Yb), lutetium (Lu), hafnium (Hf), osmium (Os), gold (Au), bismuth (Bi) and thallium (Th),
the alloying element present in the sputter target in an amount exceeding a solid solubility limit of the alloying element in hexagonal close-packed (HCP) phase ruthenium (Ru) at or above room temperature.

**19.** The sputter target of claim 18, wherein the alloying element is present in the sputter target in an amount no more than 10 atomic percent greater than the solid solubility limit of the alloying element in hexagonal close-packed (HCP) phase ruthenium (Ru) at or above room temperature.

**20.** The sputter target of claim 18, wherein the alloying element is for refining grain size in an underlayer and a granular magnetic recording layer of a magnetic recording medium.

**21.** The sputter target of claim 18, further comprising a second alloying element,
the second alloying element having a solid solubility limit in hexagonal close-packed (HCP) phase ruthenium of greater than 0 atomic percent at or above room temperature,
the second alloying element having a mass susceptibility of less than 1.5 × 10⁻⁷ m³/kg,
the second alloying element present in the sputter target in an amount not exceeding the solid solubility limit of the second alloying element.

**22.** The sputter target of claim 21, wherein the second alloying element has an atomic radius of less than 1.30 Å.

**23.** The sputter target of claim 21, wherein the second alloying element is selected from the group consisting of boron (B), carbon (C) and chromium (Cr).

**24.** The sputter target of claim 21, wherein the second alloying element has an atomic radius of greater than 1.30 Å.

**25.** The sputter target of claim 21, wherein the second alloying element is selected from the group consisting of aluminum (Al), scandium (Sc), titanium (Ti), vanadium (V), zirconium (Zr), niobium (Nb), molybdenum (Mo), palladium (Pd), lanthanum (La), cerium (Ce), lutetium (Lu), hafnium (Hf), tantalum (Ta), tungsten (W), iridium (Ir) and platinum (Pt).

**26.** A sputter target comprising:
ruthenium (Ru); and
an alloying element selected from the group consisting of boron (B), aluminum (Al), scandium (Sc), titanium (Ti), zirconium (Zr), niobium (Nb), palladium (Pd), lanthanum (La), cerium (Ce), lutetium (Lu), and hafnium (Hf),
the alloying element present in the sputter target in an amount not exceeding a solid solubility limit of the alloying element in hexagonal close-packed (HCP) phase ruthenium (Ru) at or above room temperature.

**27.** The sputter target of claim 26, wherein the alloying element is for reducing lattice misfit between an underlayer and a granular magnetic recording layer of a magnetic recording medium.

**28.** A sputter target comprising:
ruthenium (Ru); and
an alloying element selected from the group consisting of boron (B), aluminum (Al), scandium (Sc), titanium (Ti), zirconium (Zr), niobium (Nb), palladium (Pd), lanthanum (La), cerium (Ce), lutetium (Lu), and hafnium (Hf),
the alloying element present in the sputter target in an amount exceeding a solid solubility limit of the alloying element in hexagonal close-packed (HCP) phase ruthenium (Ru) at or above room temperature.

**29.** The sputter target of claim 28, wherein the alloying element is present in the sputter target in an amount no more than 10 atomic percent greater than the solid solubility limit of the alloying element in hexagonal close-packed (HCP) phase ruthenium (Ru) at or above room temperature.

**30.** The sputter target of claim 28, wherein the alloying element is for refining grain size in an underlayer and a granular magnetic recording layer of a magnetic recording medium, and for reducing lattice misfit between the underlayer and the granular magnetic recording layer.
